# EUROPEAN PATENT APPLICATION

(11) **EP 4 601 076 A2**
(43) Date of publication of application: **13.08.2025**
(21) Application number: 25184632.5
(22) Date of filing: 23.09.2022
(51) Int. Cl.: H01M 10/48

(54) **BATTERY DEVICE AND BATTERY MANAGEMENT SYSTEM**

(30) Priority: 20.10.2021 KR 20210140418
(62) Divisional of application: 22883794.4
(71) Applicant: LG Energy Solution, Ltd., Seoul 07335 (KR)
(72) Inventor: IN, Jeonghyeon, 34122 DAEJEON (KR); KWON, Young Ho, 34122 DAEJEON (KR); KIM, Cheoltaek, 34122 DAEJEON (KR)
(74) Representative: Plasseraud IP

(57) **Abstract**

A battery management system determines a charging current to charge a battery pack in each period based on a derating factor of a charge cycle including a plurality of periods, updates the derating factor based on a result of comparing a voltage of the battery pack in each period with a voltage upper limit value set in the corresponding period, and uses the updated derating factor in a next charging cycle.

## Description

### [Technical Field]

### CROSS-REFERENCE TO RELATED APPLICATION

This application claims priority to and the benefit of Korean Patent Application No. 10-2021-0140418 filed in the Korean Intellectual Property Office on October 20, 2021.

The disclosure relates to a battery device and a battery management system.

### [Background Art]

An electric vehicle or a hybrid vehicle is a vehicle that obtains power by driving a motor using a battery as a power source mainly, and its research has been actively conducted in that it is an alternative to solving the pollution and energy problems of internal combustion vehicles. In addition, rechargeable batteries are used in various external devices other than vehicles.

As the capacity of battery used in various external devices such as a vehicle increases or decreases, a technology for rapidly charging the battery has been used. A typical quick charging algorithm performs charging while reducing the current step by step from a high current to a low current so as to minimize degradation of a battery cell.

As the battery cell degrades, the resistance of the battery cell increases, and thus the voltage during charging may increase. The potential of a negative electrode of the battery cell is lowered due to a voltage rise, resulting in precipitation of an active material (e.g., lithium), which may accelerate degradation of the battery cell. At this time, the quick charging algorithm uses a logic charging the battery by reflecting the state of the battery cell. For example, a logic that lowers the charging current or charging capacity by reflecting a state of health (SOH), a logic that sets a voltage upper limit for each stage and proceeds to a next charging step when the voltage rises due to resistance degradation, etc. are used. However, due to limitations due to an estimation error of the SOH, degradation may not be completely prevented, and when the voltage upper limit is reached and the next step proceeds, the charging time may continue to increase compared to the beginning of life (BOL).

### [Disclosure]

### [Technical Problem]

Some embodiments may provide a battery device and a battery management system capable of minimizing degradation of a battery cell.

### [Technical Solution]

According to an embodiment, a battery device including a battery pack and a battery management system may be provided. The battery management system may determine a charging current to charge the battery pack in each period based on a derating factor of a charge cycle including a plurality of periods, update the derating factor based on a result of comparing a voltage of the battery pack in each period with a voltage upper limit value set in the corresponding period, and use the updated derating factor in a next charging cycle.

A basic charging current may be set in each of the plurality of periods, and the battery management system may determine the charging current by reflecting the derating factor to the basic charging current.

The battery management system may set the derating factor to be the same in the plurality of periods, and determine the charging current of the corresponding period by multiplying the derating factor by the basic charging current of each period.

The battery management system may update the derating factor based on the number of periods in which the voltage of the battery pack exceeds the voltage upper limit value among the plurality of periods.

The battery management system may reduce the derating factor when the number of periods exceeding the voltage upper limit value exceeds a threshold value.

The battery management system may maintain the derating factor when the number of periods exceeding the voltage upper limit value does not exceed the threshold value.

The battery management system may individually set the derating factor in the plurality of periods, and determine the charging current of the corresponding period by multiplying the derating factor of each period by the basic charging current of the corresponding period.

The battery management system may reduce the derating factor of a period in which the voltage of the battery pack exceeds the voltage upper limit value among the plurality of periods.

The battery management system may increase the derating factor of a period in which the voltage of the battery pack does not exceed the voltage upper limit value among the plurality of periods.

According to another embodiment, a battery management system of a battery pack may be provided. The battery management system may include a monitoring circuit monitoring a voltage of the battery pack, a memory, and a processor. The memory may store a voltage upper limit value and a derating factor in each period of a charging cycle including a plurality of periods. The processor may determine a charging current of the battery pack in each period of the charging cycle based on the derating factor, and update the derating factor based on the number of periods in which the voltage of the battery pack exceeds the voltage upper limit value among the plurality of periods.

The memory may store a magnitude of a basic charging current in each period of the charging cycle. The processor may set the derating factor to be the same in the plurality of periods, and determine the charging current of the corresponding period by multiplying the derating factor by the basic charging current of each period.

The processor may reduce the derating factor when the number of periods exceeding the voltage upper limit value exceeds a threshold value.

The processor may maintain the derating factor when the number of periods exceeding the voltage upper limit value does not exceed the threshold value.

According to another embodiment, a battery management system of a battery pack may be provided. The battery management system may include a monitoring circuit monitoring a voltage of the battery pack, a memory, and a processor. The memory may store@@@a derating factor in each period of a charging cycle including a plurality of periods and a voltage upper limit value in each period of the charging cycle. The processor may determine a charging current of the battery pack in a corresponding period based on the derating factor of each period, and update the derating factor in the corresponding period based on the voltage of the battery pack in each period and the voltage upper limit.

The memory may store a magnitude of a basic charging current in each period of the charging cycle. The processor may individually set the derating factor in the plurality of periods, and determine the charging current of the corresponding period by multiplying the derating factor in each period by the basic charging current of the corresponding period.

The processor may reduce the derating factor of a period in which the voltage of the battery pack exceeds the voltage upper limit value among the plurality of periods.

The processor may increase the derating factor of a period in which the voltage of the battery pack does not exceed the voltage upper limit value among the plurality of periods.

### [Advantageous Effect]

According to some embodiments, since the charging current may be adjusted according to the degradation state of the battery cell, the degradation of the battery cell may be minimized without excessively increasing the charging time.

### [Description of the Drawings]

FIG. 1 is a diagram showing an example of a battery device according to an embodiment.
FIG. 2 is a diagram showing an example of a voltage upper limit value in a charging cycle in a battery management system according to an embodiment.
FIG. 3 is a diagram showing an example of a basic charging current in the charging cycle in the battery management system according to an embodiment.
FIG. 4 is a flowchart illustrating an example of a charging control method in a battery management system according to an embodiment.
FIG. 5 is a flowchart illustrating an example of a charging control method in a battery management system according to another embodiment.
FIG. 6 illustrates an example of a change in charging current according to the charging control method in the battery management system according to another embodiment.
FIG. 7 is a flowchart illustrating an example of a charging control method in a battery management system according to another embodiment.
FIG. 8 illustrates an example of a voltage change according to the charging control method in the battery management system according to another embodiment.

### [Mode for Invention]

Hereinafter, the present invention will be described in detail with reference to the accompanying drawings so that those skilled in the art may easily carry out the present invention. However, the present invention may be embodied in several different forms, and is not limited to the embodiment described herein. In order to clearly describe the present invention, parts irrelevant to the description are omitted, and the same reference numerals are denoted by the same or similar components throughout the specification.

It will be understood that when a component is referred to as being "connected" to another component, the component may be directly connected to the other component, but other components may exist therebetween. On the other hand, it will be understood that when a component is referred to as being "directly connected" to another component, no other component exists therebetween.

In the description below, expressions described in the singular may be interpreted as singular or plural, unless explicit expressions such as "one" or "single" are used.

In the flowchart described with reference to the drawings, the order of operations may be changed, several operations may be merged, an operation may be divided, and certain operations may not be performed.

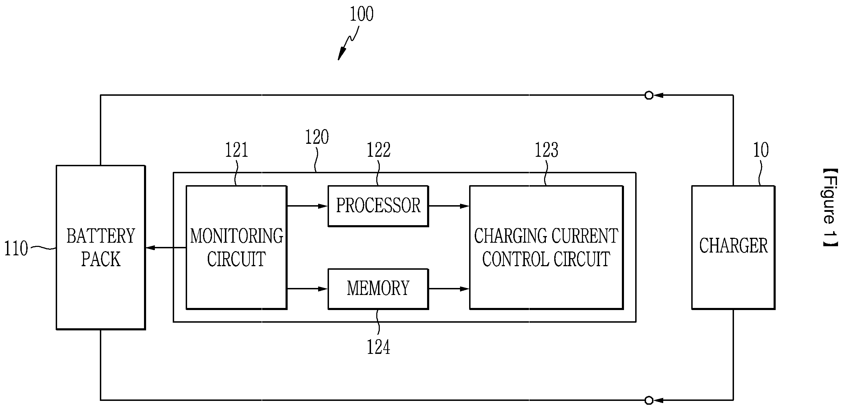

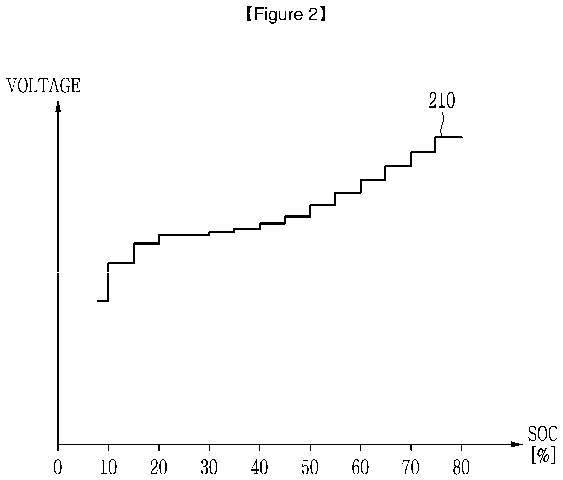

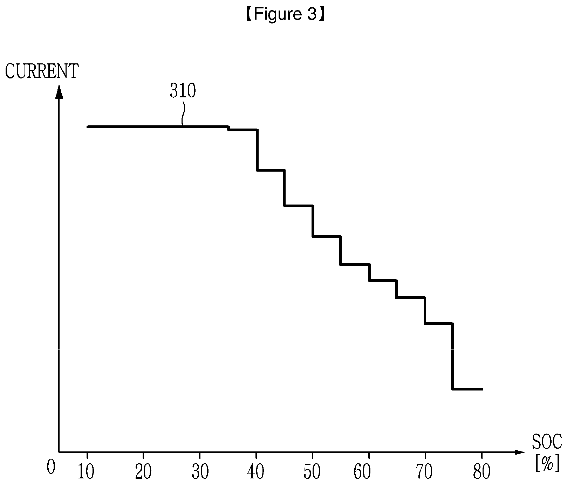

FIG. 1 is a diagram showing an example of a battery device according to an embodiment, FIG. 2 is a diagram showing an example of a voltage upper limit value in a charging cycle in a battery management system according to an embodiment, and FIG. 3 is a diagram showing an example of a basic charging current in the charging cycle in the battery management system according to an embodiment.

Referring to FIG. 1, a battery device 100 has a structure that may be electrically connected to an external device. When the external device is a load, the battery device 100 is discharged by operating as a power source supplying power to the load. When the external device is a charger 10, the battery device 100 is charged by receiving external power through the charger 10. The external device operating as a load may be, for example, an electronic device, a transportation means, or an energy storage system (ESS), and the transportation means may be a vehicle, for example, an electric vehicle, a hybrid vehicle, or a smart mobility vehicle.

The battery device 100 includes a battery pack 110 and a battery management system 120.

The battery pack 110 includes a plurality of battery cells (not shown). In some embodiments, the battery cell may be a rechargeable secondary battery. In some embodiments, a predetermined number of battery cells may be in series connected in the battery pack 110 to form a battery module and supply desired power. In some embodiments, a predetermined number of battery modules may be connected in series or parallel in the battery pack 110 to supply desired power.

The battery management system (BMS) 120 monitors the battery pack 110 and controls a charging current of the battery pack 110 based on a monitoring result of the battery pack 110 when the battery pack 110 is being charged. In some embodiments, the BMS 120 may include a monitoring circuit 121, a processor 122 and a charging current control circuit 123.

The monitoring circuit 121 may include a voltage measurement circuit monitoring the voltage of the battery pack 110. In some embodiments, the monitoring circuit 121 may further include a temperature sensor measuring the temperature of the battery pack 110. In some embodiments, the monitoring circuit 121 may further include a current sensor measuring the current of the battery pack 110, that is, the charging current or the discharging current.

The processor 122 may determine the magnitude of the charging current of the battery pack 110 based on the voltage of the battery pack 110 monitored by the monitoring circuit 121. The processor 122 may calculate a state of charge (SOC) of the battery pack 110 based on information monitored by the monitoring circuit 121. The charging current control circuit 123 may control the charging current of the battery pack 110 based on the magnitude of the charging current determined by the processor 122. That is, the charging current control circuit 123 may control the charging current supplied to the battery pack 110 from the charger 10 connected to the battery device 100 to the magnitude determined by the processor 122.

Referring to FIGS. 2 and 3, a charging cycle of the battery pack 110 is divided into a plurality of periods according to the SOC. As shown in FIG. 2, a voltage upper limit value 210 is set in each period of the charging cycle. The voltage upper limit value 210 may be set in proportion to the SOC. In some embodiments, the voltage upper limit value 210 may be set to a value capable of minimizing degradation of a battery cell, and, for example, may be previously determined through an experiment. In some embodiments, the voltage upper limit value 210 within the same period may be set to be the same. For example, the voltage upper limit value 210 in the first period may be set lower than the voltage upper limit value 210 in the second period corresponding to a SOC higher than the first period. FIG. 2 shows that the voltage upper limit value 210 is set in the range of 8 % to 80 % of the SOC, but the voltage upper limit value 210 may also be set in a range that is not shown.

As shown in FIG. 3, a basic charging current 310 is set in each period of the charging cycle. In some embodiments, the basic charging current 310 may be a charging current at the beginning of life (BOL). The magnitude of the basic charging current 310 may be set in inverse proportion to the SOC. In some embodiments, the magnitude of the basic charging current 310 within the same period may be set to be the same. For example, the basic charging current 310 in the first period may be set higher than the basic charging current 310 in the second period corresponding to the SOC higher than the first period.

In some embodiments, the BMS 120 may further include a memory 124 storing data used by the processor 122. In some embodiments, the memory 124 may store the voltage upper limit value and the magnitude of the basic charging current in each period of the charging cycle. In some embodiments, the memory 124 may store a control value (e.g., a derating factor) controlling the charging current.

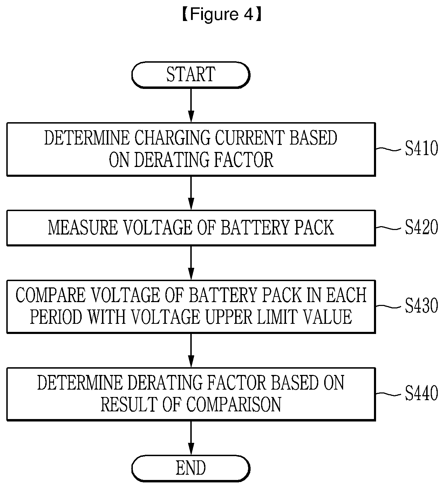

FIG. 4 is a flowchart illustrating an example of a charging control method in a battery management system according to an embodiment.

Referring to FIG. 4, a charging cycle in which a battery pack (e.g., 110 in FIG. 1) is charged by connecting a charger to the battery device starts. The battery management system (e.g., the processor (e.g., 122 of FIG. 1)) determines a charging current used to charge the battery pack 110 based on a derating factor (a current derating factor) (S410). The processor 122 may determine the charging current used to charge the battery pack 110 by reflecting the derating factor to the basic charging current (S410). In some embodiments, the processor 122 may determine a value obtained by multiplying the derating factor by the basic charging current as the charging current (S410). In some embodiments, the derating factor may be set to a basic value (e.g., 1) at the beginning of life (BOL) of the battery pack 110 and may be updated as the charging cycle is repeated. In some embodiments, the derating factor may be separately set for each period of the charging cycle. In some embodiments, the derating factor may be set to be the same in a plurality of periods of the charging cycle.

As charging progresses, the battery management system measures the voltage of the battery pack 110 (S420). In some embodiments, the monitoring circuit (e.g., 121 of FIG. 1) of the battery management system may monitor the voltage of the battery pack 110, and the processor 122 may measure the voltage of the battery pack 110 based on a monitoring result of the monitoring circuit 121.

The processor 122 compares the voltage of the battery pack 110 measured in each period of the charging cycle with a voltage upper limit value in the corresponding period (S430). The processor 122 determines a derating factor based on a comparison result between the voltage of the battery pack 110 in each period and the voltage upper limit value in the corresponding period (S440). The determined derating factor may be used to determine the charging current in a next charging cycle (S410). In some embodiments, the derating factor of the entire charging cycle may be updated based on the comparison result between the voltage of the battery pack 110 in each period and the voltage upper limit value in the corresponding period. In some embodiments, the derating factor of at least some of the plurality of periods of the charging cycle may be updated based on the comparison result between the voltage of the battery pack 110 in each period and the voltage upper limit value in the corresponding period. In some embodiments, the derating factor may be maintained without being updated based on the comparison result between the voltage of the battery pack 110 in each period and the voltage upper limit value in the corresponding period.

According to the embodiment described above, since the voltage of the battery pack 110 increases during charging as the battery cell degrades, the derating factor may be determined according to the degradation state of the battery cell. Accordingly, since the charging current may be adjusted according to the degradation state of the battery cell, the degradation of the battery cell may be minimized without excessively increasing the charging time.

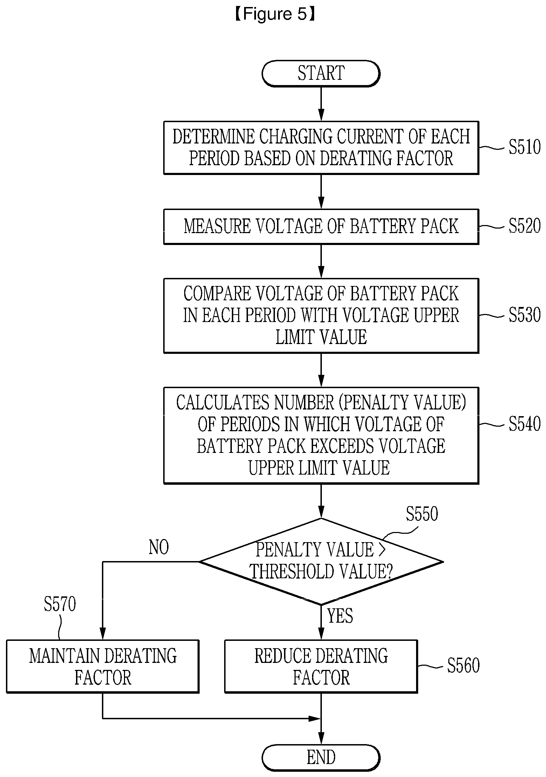

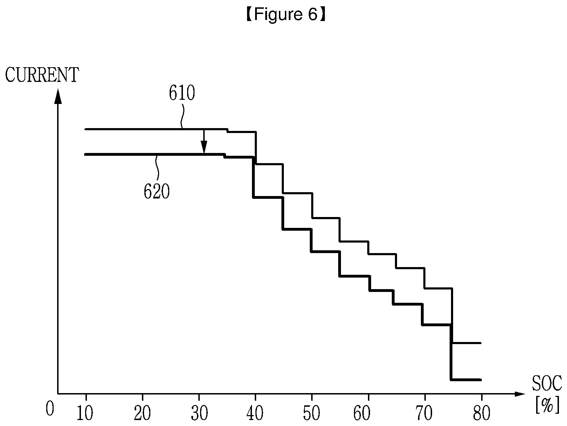

FIG. 5 is a flowchart illustrating an example of a charging control method in a battery management system according to another embodiment, and FIG. 6 illustrates an example of a change in charging current according to the charging control method in the battery management system according to another embodiment.

Referring to FIG. 5, a charging cycle in which a battery pack (e.g., 110 in FIG. 1) is charged by connecting a charger to the battery device starts. The battery management system (e.g., the processor (e.g., 122 of FIG. 1)) determines a charging current in each period of the charging cycle based on a derating factor (a current derating factor) (S510). The processor 122 may determine the charging current in each period of the charging cycle by reflecting the derating factor to a basic charging current (S510). The derating factor may be set to be the same in a plurality of periods of the charging cycle. In some embodiments, the battery management system may determine a value obtained by multiplying the basic charging current of each period by the corresponding derating factor as the charging current in the corresponding period. In some embodiments, the derating factor may be set to a basic value (e.g., 1) at the BOL of the battery pack 110 and may be updated as the charge cycle is repeated.

As charging progresses, the battery management system measures the voltage of the battery pack 110 (S520). In some embodiments, the monitoring circuit (e.g., 121 of FIG. 1) of the battery management system may monitor the voltage of the battery pack 110, and the processor (e.g., 122 of FIG. 1) may measure the voltage of the battery pack 110 based on a monitoring result of the monitoring circuit 121.

The processor 122 compares the voltage of the battery pack 110 measured in each period of the charging cycle with a voltage upper limit value in the corresponding period (S530). The processor 122 calculates a penalty value indicating the number of periods in which the voltage of the battery pack 110 exceeds the voltage upper limit value among the plurality of periods of the charging cycle (S540). In some embodiments, the processor 122 may increase a counter by 1 when the voltage of the battery pack 110 in a period exceeds the voltage upper limit value in the corresponding period, and determine a counter value as the penalty value after the plurality of periods of the charging cycle end.

The processor 122 compares the penalty value with a threshold value (S550). When the penalty value exceeds the threshold value, the processor 122 updates the derating factor (S560). In some embodiments, the processor 122 may update the derating factor by decreasing the derating factor. In some embodiments, the processor 122 may store the updated derating factor in the memory (e.g., 124 of FIG. 1). When the penalty value does not exceed the threshold value, the processor 122 maintains the derating factor without updating the derating factor (S570).

Accordingly, in a next cycle, the charging current may be determined based on the derating factor stored in the memory 124. When the voltage of the battery pack 110 frequently exceeds the voltage upper limit value (i.e., when the penalty value is greater than the threshold value), the charging current may be reduced in the next charging cycle due to the reduction of the derating factor. For example, as shown in FIG. 6, a charging current 620 in the next charge cycle may be reduced compared to a charging current 610 in the current charge cycle due to the reduction of the derating factor. In this case, since the reduced derating factor is used in the entire periods, the charging current may be reduced in the entire periods.

According to the embodiment described above, since the voltage of the battery pack 110 increases during charging as the battery cell degrades, the derating factor may be determined according to the degradation state of the battery cell. Accordingly, since the charging current may be adjusted according to the degradation state of the battery cell, the degradation of the battery cell may be minimized without excessively increasing the charging time.

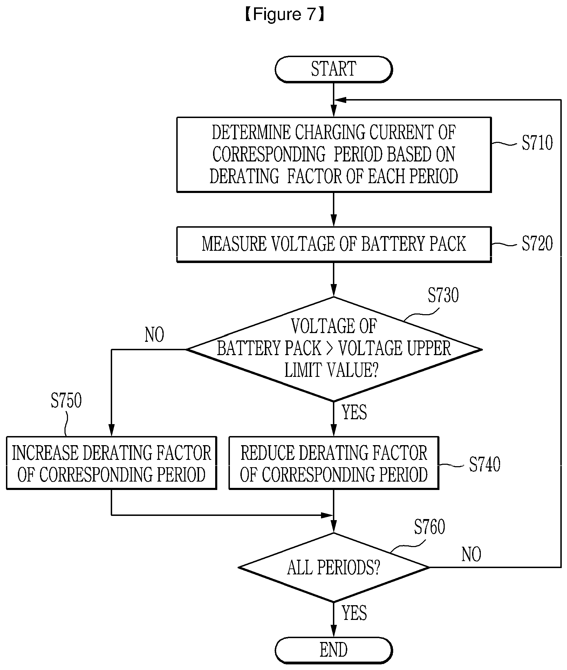

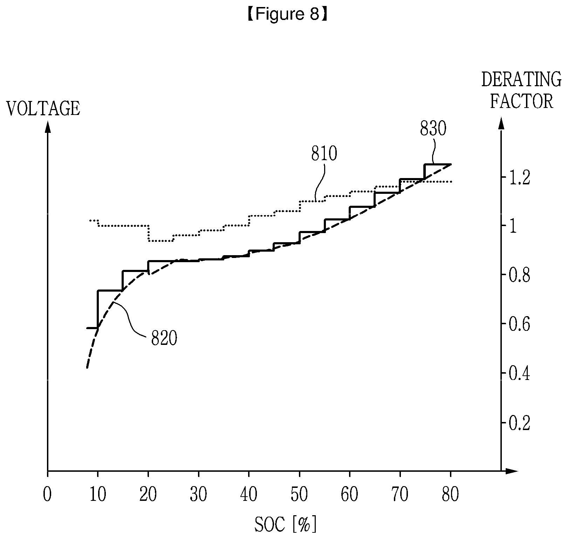

FIG. 7 is a flowchart illustrating an example of a charging control method in a battery management system according to another embodiment, and FIG. 8 illustrates an example of a voltage change according to the charging control method in the battery management system according to another embodiment.

Referring to FIG. 7, a charging cycle in which a battery pack (e.g., 110 in FIG. 1) is charged by connecting a charger to the battery device starts. The battery management system (e.g., the processor (e.g., 122 of FIG. 1)) determines a charging current in each period of the charging cycle based on a derating factor (a current derating factor) (S710). The processor 122 may determine the charging current in each period by reflecting a derating factor of the corresponding period to a basic charging current in each period of the charging cycle (S710). The derating factor is individually set in a plurality of periods of the charging cycle. In some embodiments, the battery management system may determine a value obtained by multiplying the basic charging current of each period by the derating factor in the corresponding period as the charging current in the corresponding period. In some embodiments, the derating factor may be set to a basic value (e.g., 1) at the BOL of the battery pack 110 and may be updated as the charge cycle is repeated.

As charging progresses, the battery management system measures the voltage of the battery pack 110 (S720). In some embodiments, the monitoring circuit (e.g., 121 of FIG. 1) of the battery management system may monitor the voltage of the battery pack 110, and the processor (e.g., 122 of FIG. 1) may measure the voltage of the battery pack 110 based on a monitoring result of the monitoring circuit 121.

The processor 122 compares the voltage of the battery pack 110 measured in each period of the charging cycle with a voltage upper limit value in the corresponding period (S730). In some embodiments, the processor 122 may update the derating factor of the corresponding period based on a comparison result in each period (S740 and S750). In a period, when the voltage of the battery pack 110 measured in the corresponding period exceeds a voltage upper limit value in the corresponding period, the processor 122 may update the derating factor by reducing a derating factor in the corresponding period. (S740). In a period, when the voltage of the battery pack 110 measured in the corresponding period does not exceed the voltage upper limit value in the corresponding period, the processor 122 may update the derating factor by increasing a derating factor in the corresponding period. (S750). Through this process, the processor 122 may update derating factors of the plurality of periods of the charging cycle (S760). In some embodiments, the processor 122 may store the updated derating factor in the memory (e.g., 124 of FIG. 1). In some embodiments, when the voltage of the battery pack 110 measured in a period does not exceed the voltage upper limit value in the corresponding period, the processor 122 may maintain the derating factor of the corresponding period (S750).

Accordingly, in a next cycle, the charging current may be determined based on the derating factor stored in the memory 124. In the period where the voltage of the battery pack 110 exceeds the voltage upper limit value, the processor 122 may reduce the charging current in the next charging cycle due to the reduction of the derating factor, and in the period where the voltage of the battery pack 110 does not exceed the voltage upper limit value, the processor 122 may increase the charging current in the next charging cycle due to the increase in the derating factor. Accordingly, as shown in FIG. 8, a derating factor 810 may be set for each period, and a voltage 820 of the battery pack 110 may follow a voltage upper limit value 830 during charging.

According to the embodiment described above, since the voltage of the battery pack 110 increases during charging as the battery cell degrades, the derating factor may be determined according to the degradation state of the battery cell. Accordingly, since the charging current may be adjusted according to the degradation state of the battery cell, the degradation of the battery cell may be minimized without excessively increasing the charging time. In addition, an optimal derating factor (i.e., a charging current) by which the voltage of the battery pack 110 may follow the voltage upper limit value may be determined.

In some embodiments, the processor (e.g., 122 of FIG. 1) may perform calculations on a program for executing the charging method described above. The program for executing the charging method may be loaded to a memory. The memory may be the same memory as the memory (e.g., 124 in FIG. 1) storing a table or may be a separate memory. The program may include instructions that cause the processor 122 to perform the charging method when loaded into memory. That is, the processor may perform an operation for the charging method by executing the instructions of the program.

According to Example 1, a battery device comprises: a battery pack; and a battery management system determining a charging current to charge the battery pack in each period based on a derating factor of a charge cycle including a plurality of periods, updating the derating factor based on a result of comparing a voltage of the battery pack in each period with a voltage upper limit value set in the corresponding period, and using the updated derating factor in a next charging cycle.

According to Example 2, the battery device is that of example 1, wherein: a basic charging current is set in each of the plurality of periods, and the battery management system determines the charging current by reflecting the derating factor to the basic charging current.

According to Example 3, the battery device is that of example 2, wherein: the battery management system sets the derating factor to be the same in the plurality of periods, and determines the charging current of the corresponding period by multiplying the derating factor by the basic charging current of each period.

According to Example 4, the battery device is that of example 3, wherein: the battery management system updates the derating factor based on the number of periods in which the voltage of the battery pack exceeds the voltage upper limit value among the plurality of periods.

According to Example 5, the battery device is that of example 4, wherein: the battery management system reduces the derating factor when the number of periods exceeding the voltage upper limit value exceeds a threshold value.

According to Example 6, the battery device is that of example 5, wherein: the battery management system maintains the derating factor when the number of periods exceeding the voltage upper limit value does not exceed the threshold value.

According to Example 7, the battery device is that of example 2, wherein: the battery management system individually sets the derating factor in the plurality of periods, and determines the charging current of the corresponding period by multiplying the derating factor of each period by the basic charging current of the corresponding period.

According to Example 8, the battery device is that of example 7, wherein: the battery management system reduces the derating factor of a period in which the voltage of the battery pack exceeds the voltage upper limit value among the plurality of periods.

According to Example 9, the battery device is that of example 7, wherein: the battery management system increases the derating factor of a period in which the voltage of the battery pack does not exceed the voltage upper limit value among the plurality of periods.

According to Example 10, a battery management system of a battery pack, the battery management system comprises: a monitoring circuit monitoring a voltage of the battery pack; a memory storing a voltage upper limit value and a derating factor in each period of a charging cycle including a plurality of periods; and a processor determining a charging current of the battery pack in each period of the charging cycle based on the derating factor, and updating the derating factor based on the number of periods in which the voltage of the battery pack exceeds the voltage upper limit value among the plurality of periods.

According to Example 11, the management system is that of example 10, wherein: the memory stores a magnitude of a basic charging current in each period of the charging cycle, and the processor sets the derating factor to be the same in the plurality of periods, and determines the charging current of the corresponding period by multiplying the derating factor by the basic charging current of each period.

According to Example 12, the management system is that of example 11, wherein: the processor reduces the derating factor when the number of periods exceeding the voltage upper limit value exceeds a threshold value.

According to Example 13, the management system is that of example 12, wherein: the processor maintains the derating factor when the number of periods exceeding the voltage upper limit value does not exceed the threshold value.

According to Example 14, a battery management system of a battery pack, the battery management system comprises: a monitoring circuit monitoring a voltage of the battery pack; a memory storing a derating factor in each period of a charging cycle including a plurality of periods and a voltage upper limit value in each period of the charging cycle; and a processor determining a charging current of the battery pack in a corresponding period based on the derating factor of each period, and updating the derating factor in the corresponding period based on the voltage of the battery pack in each period and the voltage upper limit.

According to Example 15, the battery management system is that of example 14, wherein: the memory stores a magnitude of a basic charging current in each period of the charging cycle, and the processor individually sets the derating factor in the plurality of periods, and determines the charging current of the corresponding period by multiplying the derating factor in each period by the basic charging current of the corresponding period.

According to Example 16, the management system is that of example 15, wherein: the processor reduces the derating factor of a period in which the voltage of the battery pack exceeds the voltage upper limit value among the plurality of periods.

According to Example 17, the management system is that of example 15, wherein: the processor increases the derating factor of a period in which the voltage of the battery pack does not exceed the voltage upper limit value among the plurality of periods.

While this invention has been described in connection with what is presently considered to be practical exemplary embodiments, it is to be understood that the invention is not limited to the disclosed embodiments. On the contrary, it is intended to cover various modifications and equivalent arrangements included within the scope of the appended claims.

## Claims

1. A battery device (100) comprising:
a battery pack (110); and
a battery management system (120) configured to:
determine a charging current to charge the battery pack in each period based on a derating factor of a charge cycle including a plurality of periods, and
maintain or update the derating factor based on a result of comparing a voltage of at least one battery included in the battery pack (110) in each period with a voltage upper limit value set in the corresponding period.

2. The battery device of claim 1, wherein the battery management system (120) is further configured to use the maintained or updated derating factor in a next charging cycle.

3. The battery device of claim 1, wherein a basic charging current is set in each of the plurality of periods, and
wherein the battery management system (120) is further configured to determine the charging current by reflecting the derating factor to the basic charging current.

4. The battery device of claim 1, wherein the battery management system (120) is further configured to:
set the derating factor to be the same in the plurality of periods, and
determine the charging current of the corresponding period by reflecting the derating factor to a basic charging current of each period.

5. The battery device of any one of claims 1 to 4, wherein the battery management system (120) is further configured to update the derating factor based on the number of periods in which the voltage of the at least one battery exceeds the voltage upper limit value among the plurality of periods.

6. The battery device of claim 5, wherein the battery management system (120) is further configured to reduce the derating factor when the number of periods exceeding the voltage upper limit value exceeds a threshold value.

7. The battery device of claim 5, wherein the battery management system (120) is further configured to increase or maintain the derating factor when the number of periods exceeding the voltage upper limit value does not exceed a threshold value.

8. The battery device of claim 1, wherein the battery management system (120) is further configured to:
individually set the derating factor in the plurality of periods, and
determine the charging current of the corresponding period by reflecting the derating factor of each period to a basic charging current of the corresponding period.

9. The battery device of any one of claims 1, 2, 3, and 8, wherein the battery management system (120) is further configured to reduce the derating factor of a period in which the voltage of the at least one battery exceeds the voltage upper limit value among the plurality of periods.

10. The battery device of any one of claims 1, 2, 3, and 8, wherein the battery management system (120) is further configured to maintain or increase the derating factor of a period in which the voltage of the at least one battery does not exceed the voltage upper limit value among the plurality of periods.

11. A charging method of a battery pack (110), the method comprising:
determining a charging current to charge the battery pack in each period based on a derating factor of a charge cycle including a plurality of periods; and
maintaining or updating the derating factor based on a result of comparing a voltage of at least one battery included in the battery pack (110) in each period with a voltage upper limit value set in the corresponding period.

12. The method of claim 11, further comprising:
setting the derating factor to be the same in the plurality of periods; and
determining the charging current of the corresponding period by reflecting the derating factor to a basic charging current of each period.

13. The method of claim 11 or 12, wherein maintaining or updating the derating factor comprises updating the derating factor based on the number of periods in which the voltage of the at least one battery exceeds the voltage upper limit value among the plurality of periods.

14. The method of claim 11, further comprising:
individually setting the derating factor in the plurality of periods; and
determining the charging current of the corresponding period by reflecting the derating factor of each period to a basic charging current of the corresponding period.

15. The method of claim 11 or 14, wherein maintaining or updating the derating factor comprises reducing the derating factor of a period in which the voltage of the at least one battery exceeds the voltage upper limit value among the plurality of periods.
